Europäisches Patentamt

European Patent Office

Office européen des brevets

(11) Numéro de publication : **0 443 924 B1**

(12) **FASCICULE DE BREVET EUROPEEN**

(45) Date de publication du fascicule du brevet :
**11.11.92 Bulletin 92/46**

(21) Numéro de dépôt : **91400407.2**

(22) Date de dépôt : **15.02.91**

(51) Int. Cl.⁵ : **F24C 7/08**

(54) **Dispositif de commande des foyers de chauffage d'un appareil de cuisson, par touches sensitives.**

(30) Priorité : **19.02.90 FR 9001968**

(43) Date de publication de la demande :
**28.08.91 Bulletin 91/35**

(45) Mention de la délivrance du brevet :
**11.11.92 Bulletin 92/46**

(84) Etats contractants désignés :
**AT BE CH DE DK ES GB GR IT LI LU NL SE**

(56) Documents cités :
**EP-A- 0 042 167**
**DE-A- 2 805 527**

(73) Titulaire : **Société SCHOLTES**
**Route de Luxembourg B.P. 48**
**F-57101 Thionville Cédex (FR)**

(72) Inventeur : **Hoffmann, Michel**
**14, rue des Peupliers**
**F-57570 Cattenom (FR)**

(74) Mandataire : **Armengaud, Alain et al**
**Cabinet ARMENGAUD AINE 3, Avenue**
**Bugeaud**
**F-75116 Paris (FR)**

## Description

La présente invention est relative à un dispositif de commande des foyers de chauffage d'un appareil de cuisson, en particulier quoique non exclusivement d'une table ou plaque de cuisson, au moyen de touches sensitives, actionnées par simple contact, sur le dessus de la plaque, du doigt de l'utilisateur.

La structure habituelle des tables de cuisson est bien connue, qui comporte, dans les réalisations les plus récentes, des foyers à commande séparée, à éléments chauffants constitués soit par des résistances électriques, soit de préférence par des lampes dites halogènes, montées dans un support dont le fond inférieur est constitué par une épaisseur suffisante d'un matériau isolant ayant des propriétés réflectives pour le rayonnement infrarouge issu des éléments chauffants, et dont la partie supérieure est formée par une plaque de verre sur laquelle reposent les récipients contenant les aliments à cuire, au droit des divers foyers.

La plaque supérieure peut être réalisée en verre feuilleté mais dans ce cas ne peut généralement pas supporter la température élevée rayonnée par les éléments chauffants. C'est pourquoi, dans les tables de cuisson modernes, elle est constituée par une plaque d'un matériau vitrocéramique, notablement plus résistant, sans gêner pour autant la transmission du rayonnement provenant des éléments chauffants.

On connaît par ailleurs diverses réalisations de touches de commande, par exemple par les publications de brevets DE-A-2 805 527 et EP-A-0 042 167, qui, par une action de contact du doigt de l'utilisateur, assurent la mise sous tension électrique des éléments chauffants, notamment par paliers successifs ou de façon régulièrement croissante ou décroissante selon le cas, en réglant l'efficacité et l'intensité du chauffage souhaité. Ces touches peuvent en particulier être réalisées sous la forme d'organes à fonctionnement électromécanique, à enfoncement, qui exigent la mise en oeuvre de moyens d'étanchéité à la traversée de la plaque de verre, par exemple à l'aide d'un film souple de plastique autocollant ou autre. Toutefois, cette solution pose des problèmes de fiabilité et surtout de durée de vie, les mouvements des touches et les flexions du film d'étanchéité en résultant, ne permettant pas d'assurer une tenue dans le temps satisfaisante. De plus, la présence sur la plaque de récipients éventuellement très chauds, risque de conduire rapidement à une détérioration du film de plastique et à un défaut d'isolation, donc à des court-circuits dans l'ensemble électrique actionné par les touches.

Une autre solution consiste à utiliser des touches sensitives à technologie résistive ou capacitive, du genre connu dans leur utilisation pour la commande par exemple des chaînes d'un téléviseur ou d'un ensemble audiophonique. Dans ce cas, chaque touche est constituée par une mince couche de métallisation, déposée sur la surface de la plaque de verre, qui comporte par le dessous un circuit électronique comprenant l'une des armatures de deux condensateurs séparés, les autres armatures, montées en série, étant formées par la couche de métallisation extérieure. Les deux condensateurs pour lesquels la plaque de verre logée entre leurs armatures joue le rôle de diélectrique, sont disposés dans un circuit monté sous la plaque et délivrant un signal approprié à un amplificateur. Lors de la mise en contact du doigt sur la couche de métallisation extérieure sur le dessus de la plaque de la touche considérée, le circuit est mis à la masse par l'intermédiaire du corps de l'utilisateur lui-même, entre les deux condensateurs en série, l'amplificateur détectant alors une variation dans le signal fourni, qui permet de commander dans le sens souhaité la puissance d'alimentation du foyer de chauffage associé à la touche.

Mais, si un tel système est d'une conception simple et présente une grande fiabilité, il n'est pas adapté dans le cas de tables de cuisson où la surface de travail supérieure est formée d'une plaque de verre vitrocéramique. En effet, dans ce cas, il n'est pas possible de métalliser localement la face supérieure de la plaque de verre, celle-ci ne permettant pas une liaison convenable avec la couche déposée. Il est donc indispensable, si l'on souhaite mettre en oeuvre la solution classique, de percer la plaque pour pouvoir toucher l'armature du condensateur, alors collée ou autrement fixée sous la face inférieure de cette plaque, ce qui pose des problèmes d'étanchéité et d'esthétique. En outre, dans le cas de projections de liquides en cours de cuisson ou de salissures au droit de la touche, ou encore de contacts accidentels avec celle-ci, se déclenchera un allumage ou une extinction intempestive du foyer de chauffage, ce qui peut avoir des conséquences préjudiciables.

On a prévu, pour pallier les inconvénients précédents, de réaliser la plaque supérieure de l'appareil au moyen d'un ensemble mixte, comportant, au-dessus des foyers de chauffage, une épaisseur appropriée de verre vitrocéramique et, rapporté sur le côté de celle-ci, un bandeau latéral étroit, portant les touches sensitives de commande, ce bandeau en verre feuilleté pouvant alors supporter une métallisation des touches comme dans les solutions classiques. Toutefois, dans ce cas, il faut réunir par soudure, collage ou autre moyen la plaque de verre vitrocéramique et le bandeau de verre feuilleté, ce qui est difficile dans une fabrication de série, peu esthétique et présente surtout des risques de rupture en fonctionnement, en raison des dilatations différentielles entre les deux types de verre utilisés.

La présente invention est relative à un dispositif de commande par touches sensitives, applicable à une table de cuisson à foyers radiants, notamment à lampes halogènes, comportant une plaque supérieure en verre vitrocéramique, donc dans laquelle ne peut pas être envisagée une métallisation extérieure de sa surface, comme dans les systèmes actuellement connus.

L'invention a également pour but de réaliser des touches sensitives, actionnées par la simple approche du doigt de l'utilisateur au droit de chaque touche, au contact ou au voisinage immédiat de la plaque de verre, sans qu'il soit nécessaire de rapporter sur la surface de celle-ci un élément quelconque, en saillie ou noyé dans la plaque, non plus que de percer celle-ci, ce qui permet de lui conserver son aspect parfaitement lisse et uniforme, en facilitant en outre son nettoyage et en procurant à l'usager une meilleure souplesse d'utilisation.

A cet effet, le dispositif considéré, pour un appareil de cuisson, en particulier pour une table de cuisson, comportant un ensemble de foyers chauffants voisins et une plaque de verre vitrocéramique, lisse et d'épaisseur uniforme, recouvrant notamment toute la table, avec une pluralité de touches sensitives actionnées par l'approche du doigt d'un utilisateur au contact ou à proximité immédiate de la surface de la plaque, se caractérise en ce que chaque touche est associée à un foyer déterminé et est constituée par les deux armatures métalliques, disposées sensiblement dans le même plan, d'un condensateur unique, porté par une plaquette de circuit imprimé, appliquée sous la plaque à l'opposé de sa surface supérieure, le condensateur présentant sa première armature réunie à un générateur d'impulsions et sa seconde armature à un comparateur différentiel, la première armature, périphérique, ayant un profil général enveloppant, entourant la seconde armature, centrale, de telle sorte que l'approche du doigt au droit du condensateur mais de l'autre côté de la plaque, vers ou contre sa surface supérieure, modifie sa capacitance et provoque, à la sortie du comparateur différentiel, un changement d'état, propre à déterminer une variation de la tension électrique d'alimentation du foyer associé à la touche.

Contrairement donc aux solutions classiques, où les touches sont métallisées sur la surface supérieure de la plaque, exigeant dès lors que celle-ci soit en verre feuilleté mais interdisant l'usage d'un verre vitrocéramique, l'invention permet d'éviter une telle métallisation et n'implique plus un contact direct, résistif ou capacitif, avec une armature commune à deux condensateurs en série, directement réalisée par cette métallisation. Selon l'invention, les deux armatures du condensateur unique ne sont plus disposées de part et d'autre de la plaque de verre mais dans le même plan, en étant portées par une plaquette de circuit imprimé, fixée contre la plaque sous cette dernière, le signal fourni par le comparateur différentiel résultant d'une variation de la valeur du diélectrique du condensateur, provoquée par l'approche du doigt de l'utilisateur de l'autre côté de la plaque.

Selon une caractéristique particulière du dispositif, la plaquette de circuit imprimé portant le condensateur, le générateur d'impulsions et le comparateur différentiel, est noyée dans une couche d'isolation et de protection contre l'humidité, réalisée sous la plaque de verre vitrocéramique et maintenant la plaquette appliquée contre celle-ci. De préférence, afin de réaliser un contact uniforme des armatures du condensateur avec la plaque de verre, notamment lorsque la surface inférieure de celle-ci est, comme il est usuel, relativement rugueuse, une couche mince intermédiaire de résine est disposée entre la plaque de verre et la plaquette. Cependant, dans d'autres modes de réalisation, les armatures du condensateur peuvent ne pas être en contact direct avec la face inférieure de la plaque de verre, la plaquette de circuit étant interposée entre cette dernière et ces armatures.

Dans un mode de réalisation préféré de l'invention, la couche d'isolation dans laquelle est noyée la plaquette est constituée d'une résine silicone, la couche mince intermédiaire étant formée au moyen d'une résine époxy ou encore d'un film transfert autocollant à double face.

Selon une autre caractéristique de l'invention, les touches sensitives ainsi réalisées, sont associées deux par deux à chaque foyer chauffant, respectivement pour provoquer, dans chaque paire, l'augmentation et la diminution de la tension d'alimentation délivrée à ce foyer, afin de régler l'allure de chauffe souhaitée.

Selon une autre caractéristique avantageuse, le dispositif comporte une touche complémentaire de déverrouillage général de l'ensemble des touches de commande, ainsi que, de préférence, une touche de verrouillage de ces dernières dans leur état instantané, pour maintenir constante l'allure de chauffe adoptée.

De préférence également, le dispositif incorpore des moyens de visualisation des allures de chauffe, constitués par des diodes électro-luminescentes, montées au voisinage de chacune des touches sous la plaque de verre, ces diodes, disposées en ligne, étant allumées ou éteintes une à une au fur et à mesure que croît ou décroît la puissance d'alimentation du foyer associé à chaque paire de touches.

De façon générale, les touches sensitives sont gérées par un micro-processeur via un circuit d'interface spécialisé, recevant l'ensemble des signaux délivrés par les comparateurs différentiels associés à ces touches. Dans un mode de réalisation particulier, le générateur d'impulsions correspondant à chaque touche, délivre des signaux carrés dont l'amplitude varie entre deux valeurs, respectivement positive et négative, choisies telles que, en l'absence d'action sur la touche, le potentiel à l'entrée du comparateur soit négatif et inférieur à une référence d'entrée, la sortie étant égale à zéro, la variation de la capacitance du condensateur consécutive à l'approche de la touche par le doigt de l'utilisateur, ramenant le potentiel à l'entrée du comparateur à une valeur positive, la sortie passant également à une valeur positive, détectée par le micro-processeur pour commander, la variation de la tension d'alimentation du foyer associé.

Selon une autre caractéristique enfin, le dispositif comporte des moyens de contrôle additionnels, notamment propres à couper l'alimentation des foyers en cas de débordement de liquides sur le dessus de la plaque de verre ou d'action sur une touche se prolongeant au-delà d'un laps de temps déterminé, de surchauffe des circuits des touches ou de localisation de récipients métalliques chauds, trop rapprochés de ces circuits.

D'autres caractéristiques d'un dispositif de commande des foyers de chauffage d'un appareil de cuisson, en particulier d'une table de cuisson, par touches sensitives selon l'invention, apparaîtront encore à travers la description qui suit d'un exemple de réalisation, donné à titre indicatif et non limitatif, en référence aux dessins annexés sur lesquels :

- La Figure 1 est une vue schématique en perspective d'une table de cuisson muni d'un dispositif de commande à touches selon l'invention.
- La Figure 2 est une vue en coupe partielle à plus grande échelle d'une partie de la table de cuisson selon la Figure 1, notamment dans la région de celle-ci comportant les touches de commande.
- La Figure 3 est une vue en coupe, à encore plus grande échelle, d'une partie de la plaque supérieure de la table de cuisson et du circuit imprimé appliqué sous cette plaque pour constituer une touche de commande.
- La Figure 4 est une vue schématique du circuit électronique correspondant à chacune des touches de la table.

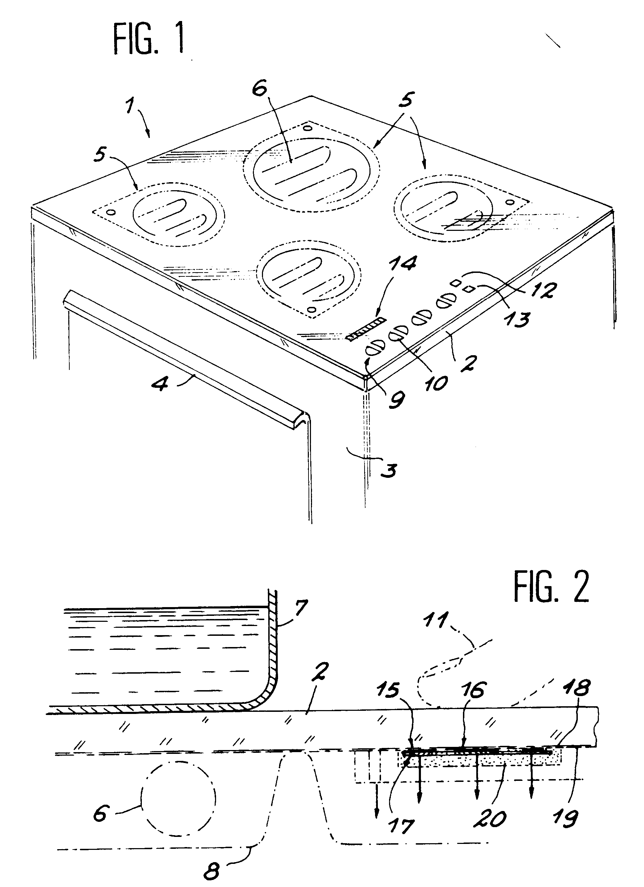

Sur la Figure 1, la référence 1 désigne une table de cuisson dont l'agencement d'ensemble est en lui-même classique, cette table comportant notamment une plaque supérieure 2 en verre vitrocéramique reposant sur un châssis de support 3, pouvant éventuellement comporter une trappe ou porte d'accès 4, par exemple pour rangement sous la table d'ustensiles de cuisine ou autres (non représentés). La table 1 comporte, dans l'exemple considéré, quatre foyers distincts, désignés de façon générale sous la référence 5, chaque foyer comprenant des éléments radiants 6 notamment constitués par des lampes à halogène. La plaque 2 couvre de façon continue toute la surface supérieure de la table 1 et s'étend au-dessus des foyers 5, les rayonnements infrarouges issus de ces foyers traversant la plaque de manière à venir chauffer un récipient quelconque 7 (Figure 2), posé sur le dessus de cette plaque au droit d'un quelconque des foyers 5. La table 1 comporte de manière en elle-même connue, un fond inférieur 8, schématiquement représenté et de préférence réalisé en un matériau présentant des qualités convenables d'isolation thermique et de réflectivité en direction de la plaque 2 des rayons issus des lampes 6.

Sur un des côtés latéraux de la table 1, est prévue une zone de commande des allures de chauffe des divers foyers 5, permettant à volonté d'augmenter ou de diminuer la tension d'alimentation des lampes et par suite le rayonnement qu'elles délivrent, ou encore de faire varier le rapport des puissances dans le cas d'une commande par tout ou rien pour des foyers mixtes combinant des lampes halogènes et des résistances chauffantes, de façon en soi connue dans la technique. La zone 9 est constituée par un ensemble de touches sensitives 10 selon l'invention, dont le détail est décrit ci-après, ces touches formant ensemble un clavier de commande de la table de cuisson, étant associées deux par deux, comme le représente la Figure 1, de telle sorte que chaque foyer 5 corresponde à une paire de touches, l'une servant à incrémenter la puissance délivrée au foyer associé à chaque contact du doigt 11 de l'utilisateur sur cette touche, tandis que l'autre sert, à l'inverse, à diminuer pas à pas la puissance de ce même foyer.

Sur la Figure 1, apparaissent également deux touches complémentaires, analogues aux précédentes, l'une 12 servant à réaliser un déverrouillage général de l'ensemble des touches 10 de la table 1, tandis que l'autre 13 permet de verrouiller toutes les touches dans un état donné au moment où elle est actionnée, afin de maintenir constante l'allure de chauffe du ou des foyers 5 correspondants. Des diodes électroluminescentes 14 disposées en ligne, sont prévues à côté des touches 10, afin de visualiser la situation de chacun des foyers, notamment des allures de chauffe imposées à ces derniers par la commande des touches.

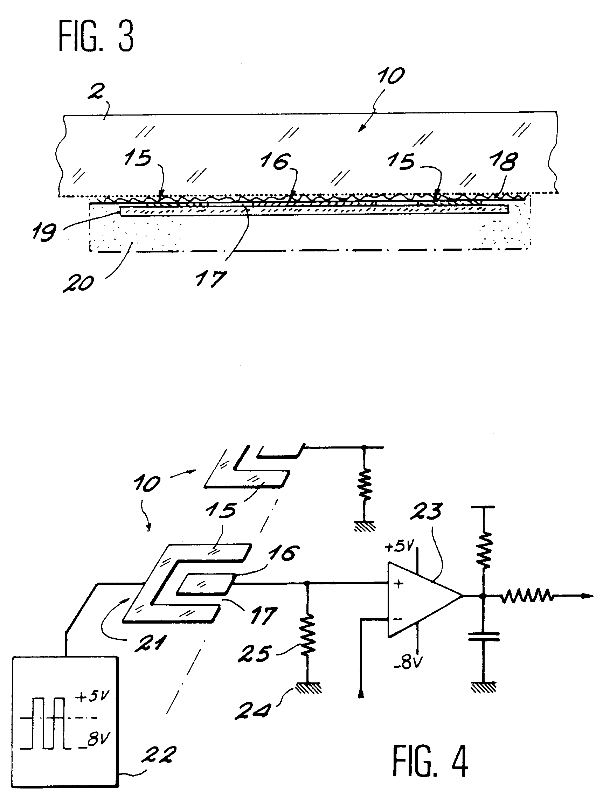

Comme on le voit sur la Figure 2 et plus en détail encore sur la Figure 3, chacune des touches 10 est essentiellement constituée de deux armatures métalliques, respectivement 15 et 16, l'armature 15 ou périphérique présentant sensiblement la forme d'un U (voir Figure 4), tandis que l'armature 16, dite centrale, est disposée entre les deux branches de l'armature périphérique 15. Les armatures 15 et 16 sont situées dans le même plan et en particulier font partie d'une plaquette de circuit imprimé 17, appliquée contre la face inférieure 18 de la plaque de verre vitrocéramique 2, cette dernière présentant généralement une surface relative rugueuse, comme le montre la Figure 3. Avantageusement, cette surface 18 est recouverte d'une couche 19 de résine époxy contre laquelle vient s'appliquer la plaquette de circuit imprimé 17, cette dernière étant à son tour noyée dans une couche isolante 20 d'une résine silicone qui protège le circuit vis-à-vis de l'humidité, et en particulier des condensations pouvant se produire en fonctionnement, sous la plaque 2, du fait des variations des allures de chauffe et de l'atmosphère ambiante. En variante, le circuit imprimé peut être complètement noyé dans un enrobage de résine silicone, lui-même appliqué et fixé sous la face inférieure de la plaque de verre, ce qui évite l'emploi d'une couche de résine intermédiaire.

Les deux armatures 15 et 16 forment ensemble un condensateur unique, dont le diélectrique est constitué par l'environnement de ces armatures, notamment par le matériau de la plaquette 17, les couches de résine 19 et 20 et la plaque de verre vitrocéramique 2. Bien entendu, la forme en U de l'armature périphérique associée à une armature centrale pourrait être modifiée sans sortir du cadre de l'invention. Ainsi, on pourrait envisager une armature centrale de forme sensiblement circulaire et une armature périphérique à profil arrondi entourant partiellement la première. De même, on pourrait prévoir de réaliser les deux armatures en forme de peignes dont les dents s'imbriquent, chaque dent de la seconde armature étant de préférence disposée entre deux dents parallèles de l'autre armature.

Comme on le voit sur la Figure 4, le condensateur formé par les deux armatures 15 et 16, désigné dans son ensemble sous la référence 21, est réuni d'une part, par l'armature 16 à un générateur d'impulsions 22 et d'autre part, par l'armature 15 à un comparateur différentiel 23, la liaison étant raccordée à la masse 24 par une résistance. Le générateur 22 délivre des signaux carrés dont l'amplitude varie, dans l'exemple plus spécialement représenté, entre une valeur positive de + 5 v. et une valeur négative de - 8 v. Le comparateur 23 reçoit sur son entrée négative une tension de référence de - 0,9 v. et sur son entrée positive, lorsque la touche 10 correspondante n'est pas activée, une tension négative de - 3 v. Le potentiel sur l'entrée du comparateur étant inférieur à la tension de référence, la sortie de ce dernier est au potentiel zéro.

Lorsque le doigt 11 de l'utilisateur vient au contact ou à proximité immédiate de la plaque 2 au droit de la touche 10 considérée, il modifie la valeur du diélectrique du condensateur 21 de telle manière que le potentiel à l'entrée du comparateur 23 soit pratiquement ramené à zéro. Dans ces conditions, la sortie de ce même comparateur passe de zéro à une valeur positive, qui peut être détectée par un unn micro-processeur (non représenté), adapté à gérer l'ensemble des signaux issus des touches 10, en fonction de la demande et du réglage recherché des allures de chauffe des divers foyers 5.

Avantageusement, le dispositif à touches sensitives ainsi réalisé est associé à d'autres organes de contrôle et de sécurité. Ainsi le micro-processeur peut être programmé de telle sorte que, lorsqu'une touche quelconque est actionnée pendant plus de dix secondes, se produise un arrêt total de la commande des foyers, cette situation se présentant par exemple en cas de débordement d'un liquide sur le dessus de la plaque 2 ou lorsque l'utilisateur a, par inadvertance, placé sur une touche un objet quelconque, réalisant fictivement la commande de cette touche de la même manière que par le contact du doigt de la façon précisée plus haut. Un clignotement continu ou alterné des diodes 14 peut permettre dans ce cas d'avertir l'utilisateur d'un tel disfonctionnement. Dans le cas d'une telle anomalie, la puissance est automatiquement coupée. Après suppression du défaut, une action sur la touche de déverrouillage est rendue nécessaire pour remettre le clavier de touches en état de fonctionner.

En complément, un capteur de température peut être prévu au voisinage des touches 10, pour provoquer de la même manière, la mise hors service des foyers lorsque se produit une surchauffe locale pouvant, le cas échéant, détériorer les circuits de commande. Enfin, un autre capteur, magnétique ou autre (non représenté) peut également être prévu pour détecter la présence d'un récipient au contact des touches, les actionnant intempestivement, ce capteur pouvant être réuni à une alarme sonore dont le but est d'avertir l'utilisateur que le récipient est disposé trop près de la zone de commande et des circuits électroniques qu'elle comporte.

On réalise ainsi un dispositif de commande des foyers de chauffage d'un appareil de cuisson au moyen de touches sensitives ne nécessitant aucune métallisation de la surface supérieure de la plaque de verre, celle-ci comportant seulement des repères sérigraphiés ou autrement dessinés sur cette surface pour préciser l'emplacement des touches et leurs affectations aux différents foyers. L'ensemble est sûr et fiable et d'un entretien inexistant, la surface de la plaque de verre étant totalement libre, ce qui facilite son nettoyage et son entretien.

Le dispositif permettant de détecter la présence d'un récipient au moyen d'un capteur magnétique ou capacitif pourrait être prévu au voisinage de chacun des foyers halogènes, de manière à n'allumer celui-ci que dans le cas où ce récipient est convenablement posé au-dessus du foyer. Une telle disposition présente l'avantage que l'utilisateur n'est jamais ébloui par la lumière issue du foyer, ce dernier étant éteint automatiquement lorsque l'on retire le récipient et se rallumant sans autre intervention lorsque l'utilisateur repose le récipient sur le dessus de la plaque.

## Revendications

1. Dispositif de commande des foyers de chauffage d'un appareil de cuisson, notamment d'une table de cuisson, comportant un ensemble de foyers chauffants (5) voisins et une plaque de verre vitrocéramique (2), lisse et d'épaisseur uniforme, recouvrant notamment toute la table, avec une pluralité de touches sensitives (10) actionnées par l'approche du doigt (11) d'un utilisateur au contact ou à proximité immédiate de la surface de la plaque, caractérisé en ce que chaque touche (10) est associée à un foyer déterminé (5) et est constituée par les deux armatures métalliques (15-16) disposées sensiblement dans le même plan d'un condensateur unique, porté par une plaquette de circuit imprimé (17), appliquée sous la plaque à l'opposé de sa surface supérieure, le condensateur ayant sa première armature (15) réunie à un générateur d'impulsions et sa seconde armature (16) à un comparateur différentiel (23), la première armature, périphérique, ayant un profil général enveloppant, entourant la seconde armature, centrale, de telle sorte que l'approche du doigt au droit du condensateur mais de l'autre côté de la plaque, vers ou contre sa surface supérieure, modifie sa capacitance et provoque, à la sortie du comparateur différentiel, un changement d'état, propre à déterminer une variation de la tension électrique d'alimentation du foyer associé à la touche.

2. Dispositif de commande selon la revendication 1, caractérisé en ce que la plaquette de circuit imprimé (17) portant le condensateur (21), le générateur d'impulsions (22) et le comparateur différentiel (23) est noyée dans une couche d'isolation et de protection (20) contre l'humidité, réalisée sous la plaque de verre vitrocéramique (2) et maintenant la plaquette appliquée contre celle-ci.

3. Dispositif de commande selon l'une des revendications 1 ou 2, caractérisé en ce qu'une couche mince intermédiaire de résine (19) est disposée entre la plaque de verre (2) et la plaquette (17).

4. Dispositif de commande selon l'une des revendications 2 ou 3, caractérisé en ce que la couche d'isolation (20) est constituée d'une résine silicone, la couche mince intermédiaire (19) étant formée au moyen d'une résine époxy.

5. Dispositif de commande selon l'une quelconque des revendications 1 à 4, caractérisé en ce que les touches sensitives (10) sont associées deux par deux par paire à chaque foyer chauffant (5), respectivement pour provoquer, dans chaque paire, l'augmentation et la diminution de la tension d'alimentation délivrée à ce foyer, afin de régler l'allure de chauffe souhaitée.

6. Dispositif de commande selon l'une quelconque des revendications 1 à 5, caractérisé en ce qu'il comporte des touches de commande, ainsi que, de préférence, une touche de verrouillage (13) de ces dernières dans leur état instantané, pour maintenir constante l'allure de chauffage adoptée.

7. Dispositif de commande selon l'une quelconque des revendications 1 à 6, caractérisé en ce qu'il incorpore des moyens de visualisation (14) des allures de chauffe, constitués par des diodes électroluminescentes, montées au voisinage de chacune des touches (10) sous la plaque de verre (2), ces diodes, disposées en ligne, étant allumées ou éteintes une à une au fur et à mesure que croît ou décroît la puissance d'alimentation du foyer (5) associé à chaque paire de touches.

8. Dispositif de commande selon l'une quelconque des revendications 1 à 7, caractérisé en ce que les touches sensitives (10) sont gérées par un micro-processeur via un circuit d'interface spécialisé, recevant l'ensemble des signaux délivrés par les comparateurs différentiels (23) associés à ces touches.

9. Dispositif de commande selon l'une quelconque des revendications 1 à 8, caractérisé en ce qu'il comporte des moyens de contrôle additionnels, notamment propres à couper l'alimentation des foyers en cas de débordement de liquides sur le dessus de la plaque de verre ou d'action se prolongeant au-delà d'un laps de temps déterminé, de surchauffe des circuits des touches ou de localisation de récipients métalliques chauds, trops rapprochés de ces circuits.

**Patentansprüche**

1. Vorrichtung zur Heizstellenregelung bei einem Kochgerät, besonders einer tischartigen Kochmulde, die eine Anordnung von benachbarten Heizstellen (5) und eine glatte Glaskeramikplatte (2) von gleichmäßiger Dicke, die insbesondere die ganze Mulde bedeckt, mit einer Mehrzahl von Sensortasten (10) aufweist, die durch die Annäherung des Fingers (11) eines Benutzers bis zur Berührung oder in nächste Nähe der Oberfläche der Platte betätigt werden, dadurch gekennzeichnet, daß jede Taste (10) einer bestimmten Heizstelle (5) zugeordnet ist und aus den zwei im wesentlichen in derselben Ebene angeordneten Metallbelägen (15, 16) eines einzigen Kondensators besteht, der von einem Plättchen einer gedruckten Schaltung (17) getragen ist, das unter der Platte gegenüber deren oberer Fläche angebracht ist, wobei der erste Belag (15) des Kondensators mit einem Impulsgenerator und sein zweiter Belag (16) mit einem Differential-Komparator (23) verbunden sind und der erste periphere Belag einen im ganzen umhüllenden Umriß hat und den zweiten zentralen Belag umgibt, so daß die Annäherung des Fingers im Bereich des Kondensators aber von der anderen Seite der Platte her in Richtung auf deren Oberfläche oder bis zur Berührung damit dessen Kapazitanz verändert und am Ausgang des Differential-Komparators eine Zustandsänderung bewirkt, die dazu dient, eine Veränderung der elektrischen Speisespannung des zur Taste gehörenden Heizfeldes zu bestimmen.

2. Regelungsvorrichtung nach Anspruch 1, dadurch gekennzeichnet, daß das den Kondensator (21), den Impulsgenerator (22) und den Differential-Komparator (23) tragende Plättchen der gedruckten Schaltung (17) in eine unter der Glaskeramikplatte (2) ausgebildete Isolationsschicht (20) eingebettet ist, die auch dem Schutz gegen Feuchtigkeit dient und das Plättchen gegen die Glaskeramikplatte angelegt hält.

3. Regelvorrichtung nach einem der Ansprüche 1 oder 2, dadurch gekennzeichnet, daß zwischen der Glasplatte (2) und dem Plättchen (17) eine dünne Kunstharzzwischenschicht (19) angeordnet ist.

4. Regelvorrichtung nach einem der Ansprüche 2 oder 3, dadurch gekennzeichnet, daß die Isolationsschicht (20) aus einem Siliconharz besteht und die dünne Zwischenschicht (19) mittels eines Epoxyharzes gebildet ist.

5. Regelvorrichtung nach einem der Ansprüche 1 - 4, dadurch gekennzeichnet, daß jeweils zwei der Sensortasten (10) paarweise jeder Heizstelle (5) zugeordnet sind, um jeweils in jedem Paar die Erhöhung und Verringerung der dieser Heizstelle zugeführten Speisespannung zu bewirken um die gewünschte Heizleistung zu regeln.

6. Regelvorrichtung nach einem der Ansprüche 1 - 5, dadurch gekennzeichnet, daß sie Steuertasten sowie vorzugsweise eine Verriegelungstaste (13) aufweist, welche die Steuertasten in ihrem augenblicklichen Zustand verriegelt, um die gewählte Heizleistung konstant zu halten.

7. Regelvorrichtung nach einem der Ansprüche 1 - 6, dadurch gekennzeichnet, daß sie eine Anzeigevorrichtung (14) für die Heizleistungen aufweist, welche aus in der Nähe jeder der Tasten (10) unter der Glasplatte (2) montierten Elektrolumineszenz-Dioden besteht, die in einer Reihe angeordnet nacheinander im Maß der Steigerung oder Verringerung der Speiseleistung der zu jedem Paar von Tasten gehörenden Heizstelle (5) aufleuchten oder erlöschen.

8. Regelvorrichtung nach einem der Ansprüche 1 - 7, dadurch gekennzeichnet, daß die Sensortasten (10) durch einen Mikroprozessor über eine spezielle Interface-Schaltung gesteuert werden, die die Gesamtheit der von den zu diesen Tasten gehörenden Differential-Komparatoren (23) gelieferten Signale empfängt.

9. Regelvorrichtung nach einem der Ansprüche 1 - 8, dadurch gekennzeichnet, daß sie eine zusätzliche Kontrollvorrichtung aufweist, die insbesondere geeignet ist, die Stromversorgung der Heizstellen zu unterbrechen im Fall von Überlaufen von Flüssigkeiten auf der Oberseite der Glasplatte oder einer länger als eine bestimmte Zeit dauernden Maßnahme, der Überhitzung der Sensortastenkreise oder dem Abstellen von heißen Metallgefäßen zu nahe an diesen Schaltkreisen.

**Claims**

1. Device for controlling the heating rings of a cooker, in particular of a cooker hob, comprising an arrangement of adjacent heating rings (5) and a sheet of vitroceramic glass (2), which is smooth and of uniform thickness, covering in particular the entire hob, with a plurality of sensitive contacts (10) actuated by the approach of the finger (11) of a user in contact with or in the immediate vicinity of the surface of the sheet, characterised in that each contact (10) is associated with a predetermined ring (5) and is constituted by the two metal plates (15-16) arranged substantially in the same plane of a single capacitor, carried by a printed circuit board (17), fitted below the glass sheet opposite its upper surface, the capacitor having its first plate (15) connected to a pulse generator and its second plate (16) to a differential comparator (23), the first peripheral plate having a general enveloping profile, surrounding the second central plate, in such a way that the approach of the finger opposite the capacitor, but on the other side of the glass sheet, towards or against its upper surface, changes its capacitance and causes, at the output of the differential comparator, a change of state, able to determine a variation in the electrical supply voltage of the ring associated with the contact.

2. Control device according to Claim 1, characterised in that the printed circuit board (17) carrying the capacitor (21), the pulse generator (22) and the differential comparator (23) is embedded in an insulating layer (20) which protects against humidity, provided below the vitroceramic glass sheet (2) and holding the board applied against the latter.

3. Control device according to one of Claims 1 or 2, characterised in that a thin intermediate layer of resin (19) is placed between the sheet of glass (2) and the board (17).

4. Control device according to one of Claims 2 or 3, characterised in that the insulation layer (20) is constituted by a silicone resin, the thin intermediate layer (19) being formed by means of an epoxy resin.

5. Control device according to one of Claims 1 to 4, characterised in that the sensitive contacts (10) are associated in pairs with each heating ring (5), respectively in order to cause, in each pair, the increase and reduction of the supply voltage supplied to this ring, in order to regulate the desired heating capacity.

6. Control device according to one of Claims 1 to 5, characterised in that it comprises control contacts, as well as, preferably, a contact (13) for locking the latter in their instantaneous state, for keeping the adopted heating capacity constant.

7. Control device according to one of Claims 1 to 6, characterised in that it incorporates means (14) for indicating the heating capacities, constituted by electroluminescent diodes, mounted in the vicinity of each of the contacts (10) below the sheet of glass (2), these diodes, arranged in a line, being illuminated or extinguished one by one as the power supplied to the ring (5) associated with each pair of contacts increases or decreases.

8. Control device according to one of Claims 1 to 7, characterised in that the sensitive contacts (10) are controlled by a microprocessor via a specialised interface circuit, receiving all the signals supplied by the differential comparators (23) associated with these contacts.

9. Control device according to one of Claims 1 to 8, characterised in that it comprises additional control means, in particular able to interrupt the supply of power to the rings in the case of the boiling-over of liquids onto the top of the sheet of glass or of action extending beyond a predetermined period of time, of overheating of the circuits of the contacts or the location of hot metal containers, too close to these circuits.

FIG. 1

FIG. 2

FIG. 3

FIG. 4